# EUROPEAN PATENT SPECIFICATION

(11) **EP 0 474 445 B1**
(45) Date of publication and mention of the grant of the patent: **16.12.1998**
(21) Application number: 91307989.3
(22) Date of filing: 30.08.1991
(51) Int. Cl.: G03B 41/00, G03F 9/02

(54) **Autofocusing device and projection exposure apparatus with the same**
Automatische Fokussierungsvorrichtung und Projektionsbelichtungsgerät mit einer solchen Anordnung
Dispositif d'autofocus et appareil de projection pour exposition muni d'un tel système

(30) Priority: 06.09.1990 JP 237900/90
(43) Date of publication of application: 11.03.1992
(73) Proprietor: CANON KABUSHIKI KAISHA, Tokyo (JP)
(72) Inventor: Kataoka, Yoshiharu, c/o Kosugi Jigyosho, Kawasaki-shi, Kanagawa-ken (JP); Suzuki, Akiyoshi, c/o Kosugi Jigyosho, Kawasaki-shi, Kanagawa-ken (JP); Yamada, Yuichi, c/o Kosugi Jigyosho, Kawasaki-shi, Kanagawa-ken (JP)
(74) Representative: Beresford, Keith Denis Lewis

(56) References cited:
- EP-A- 342 061
- DD-A- 269 471
- JP-A-63 163 833
- US-A- 4 650 983
- US-A- 4 668 077
- US-A- 4 705 940
- PATENT ABSTRACTS OF JAPAN vol. 11, no. 27 (E-474) 27 January 1987, & JP-A-61 196532 (CANON) 30 August 1986
- PATENT ABSTRACTS OF JAPAN vol. 13, no. 144 (E-740) 10 April 1989, & JP-A-63 306626 (NIKON) 14 December 1988
- PATENT ABSTRACTS OF JAPAN vol. 10, no. 209 (E-421) 22 July 1986, & JP-A-61 048923 (NEC CORP) 10 March 1986

## Description

### FIELD OF THE INVENTION AND RELATED ART

This invention relates to an autofocusing device and a projection exposure apparatus with the same. More particularly, the invention in an aspect is concerned with an autofocusing device for bringing different portions of a substrate sequentially into focus with a focal plane of a projection optical system. In another aspect, the invention is concerned with a semiconductor device manufacturing reduction projection exposure apparatus (called a "stepper") for placing, sequentially, different exposure areas (pattern forming areas) of a semiconductor wafer, supported on a wafer stage, into coincidence with a focal plane of a projection optical system such as a reduction projection lens system and then for printing an image of a circuit pattern of a reticle (original) onto each exposure area of the wafer.

Enlarging numerical aperture (NA) of a reduction projection lens system of a stepper required by further increases in the degree of integration of a very large scaled integrated circuit (VLSI) and consequent further miniaturization of a circuit pattern to be printed, has forced a reduction of the depth of focus of the lens system in the pattern transfer process. Also, it has forced enlargement of the size of an exposure area to be exposed by the reduction projection lens system.

This necessitates assured positioning of each exposure area (shot area) of a wafer, as a whole, correctly within the depth of focus of a reduction projection lens system, for assured transfer of a circuit pattern onto the exposure area as a whole which is large in size.

To this end, it is important to detect the position or inclination of the surface of a wafer with respect to a focal plane of a reduction projection lens system (i.e. a plane on which an image of a circuit pattern of a reticle is focused) very precisely and, also, to adjust the position or inclination of the wafer surface correctly.

As for a method of detecting the wafer surface position in a stepper, there is a method wherein air microsensors are used to detect levels at different locations on the surface of a wafer and, based on this detection, the surface position of the wafer is determined. Also, there is a method wherein a detection optical system is used to project light obliquely onto the surface of a wafer and any positional deviation of the reflection point on the wafer surface is detected by detecting a shift of the position of reflected light incident on a sensor, whereby the position of the wafer surface is determined.

In any case, for the autofocusing operation in a stepper, a wafer stage is moved by servo controlled drive to a target position with its displacement being measured through laser interferometer means, to thereby move an exposure area of a wafer up to a station just underneath a projection lens system. After the wafer stage stops, the surface position of that exposure area is measured in the manner as described above and, then, the position of that exposure area is adjusted. Namely, the autofocusing operation includes sequential steps of wafer stage drive, wafer stage stop, surface position detection and surface position adjustment. This requires a relatively long time to complete the focusing of each exposure area with respect to the focal plane of the projection lens system and thus causes reduced throughput of the exposure apparatus.

It is accordingly a concern of the present invention to provide an improved autofocusing method or device with which the autofocusing operation can be accomplished in a reduced time.

It is another concern of the present invention to provide a projection exposure apparatus with such an autofocusing device.

European Patent Specification No. EP-A-0,342,061 discloses a step-and-repeat projection exposure apparatus which detects when a wafer has reached an exposure location but does not carry out detection and control of the movement of the wafer during movement. Instead it detects the moment when the wafer has arrived at the desired location.

US Patent Specification No. 4,705,940 discloses a projection optical system for projecting a pattern of a mask onto a wafer in which astigmatism in the optical system is connected with respect to a predetermined region of the field of the projection optical element.

US Patent Specification No. 4,650,983 discloses a projection optical system for exposing wafers in which the position of a wafer with respect to the optical axis direction of the optical system is detected whilst using the wafer along the optical axis direction.

In accordance with one aspect of the present invention, there is provided an autofocusing device as set out in claim 1.

In accordance with a second aspect of the present invention, there is provided a method of exposing wafers as set out in claim 4.

These and other features and advantages of the present invention will become more apparent upon a consideration of the following description of the preferred embodiments of the present invention taken in conjunction with the accompanying drawings.

### BRIEF DESCRIPTION OF THE DRAWINGS

Figure 1 is a schematic view of a main portion of a reduction projection exposure apparatus into which the present invention is incorporated.

Figure 2 illustrates the points on an exposure area which might be irradiated with light beams from a detection optical system when the exposure area is positined at the exposure station.

Figure 3 is a plan view showing the layout of exposure areas (shot areas) on a wafer.

Figure 4 is a graph for exemplifying surface levels measured at different measuring points, which levels change with the movement of a wafer stage.

Figure 5 is a flow chart showing an example of autofocusing operation to be executed with the device of Figure 1.

Figure 6 is a flow chart showing another example of autofocusing operation to be executed with the device of Figure 1.

### DESCRIPTION OF THE PREFERRED EMBODIMENTS

An autofocusing device according to an aspect of the present invention may be so arranged that: A stage for supporting a sheet-like object such as a wafer moves in a direction substantially orthogonal to an optical axis of a projection optical system, so as to move a particular surface portion of the object to an image plane of the projection optical system. A detector detects at least one of a position and inclination of the particular surface portion of the object with respect to the direction of the optical axis of the projection optical system. The detection through the detector is executed during the movement of the stage and, on the basis of this detection, the particular surface portion of the object is brought into focus with the focal plane of the projection optical system.

With this arrangement, the surface position detection can be executed before the stage, being moved, reaches and stops at a target position. As a result, for example, the adjustment of the surface position can be initiated during movement of the stage. This assures reduced time for the autofocusing operation and, when such an autofocusing device is incorporated into a stepper, it ensures enhanced throughput of the stepper.

For placing a particular surface portion of a sheet-like object in focus with the focal plane of a projection optical system on the basis of the detection by a detector, many methods are adoptable. An example is a method wherein a stage is moved along the optical axis of the projection optical system, to thereby adjust the position or inclination of the particular surface portion. Another example is a method wherein the projection optical system is displaced in the direction of the optical axis thereof or, alternatively, the focal length of the projection optical system is changed, to thereby shift the focal plane thereof. Where the focal length (refracting power) of the projection optical system is to be changed, the wavelength of light to be used for the projection may be changed or, alternatively, one or more lenses of the projection optical system may be displaced along the optical axis. As a further alternative, an air chamber may be defined between a pair of lenses of the projection optical system and the pressure in that chamber may be changed.

The detector means is not limited to air sensor means. Optical sensor means, electrostatic capacitance sensor means, or any other type sensor means may be used. For detection of inclination of a particular surface of a sheet-like object such as a wafer, plural sensors such as air sensors or optical sensors may be used to execute level (surface position) measurement at different points on the particular surface. Alternatively, a parallel light may be projected onto the particular surface and the position of incidence of the parallel light, as reflected by the particular surface and converging on a photodetector, may be detected.

An autofocusing method or device of the present invention may be incorporated into any type of exposure apparatus using X-rays, an electron beam or any other short-wavelength radiation beam, for the pattern printing.

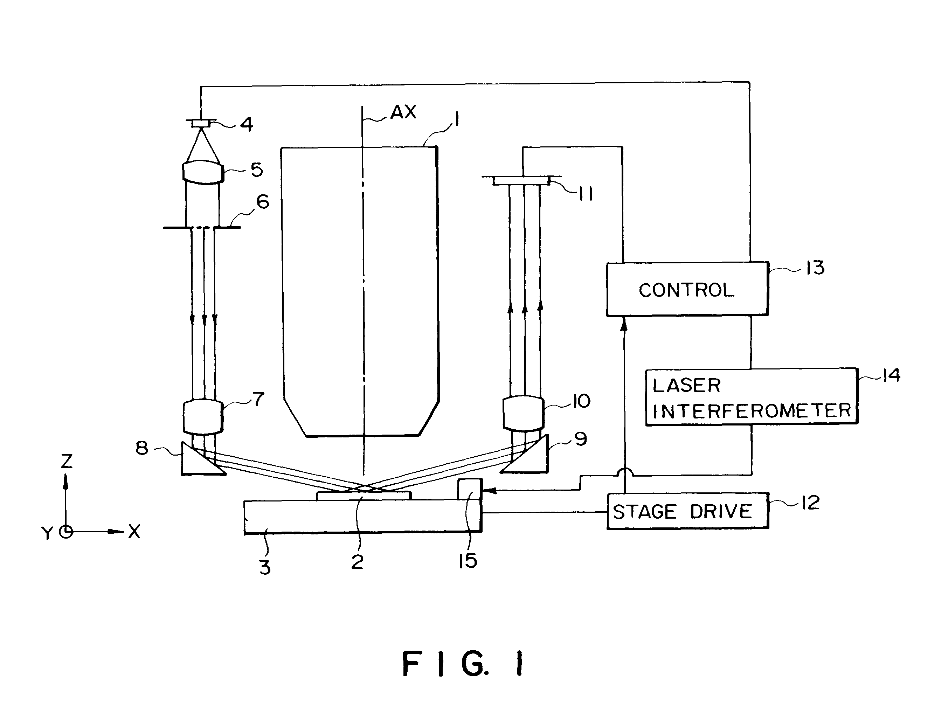

Referring now to Figure 1 which is a schematic view of a main portion of a semiconductor device manufacturing reduction projection exposure apparatus into which an embodiment of the present invention is incorporated, denoted 1 is a reduction projection lens system having an optical axis AX. The reduction projection lens system 1 serves to project a circuit pattern of a reticle (not shown) in a reduced scale of 1:5, and to form an image of the circuit pattern on its focal plane. In the drawing, the optical axis AX is held parallel to Z axis illustrated. Denoted at 2 is a wafer having a surface coated with a resist. On the surface of the wafer 2, there are a number of arrayed exposure areas (shot areas) having the same patterns printed through the preceding exposure process or processes. Wafer stage 3 supports and holds the wafer 2 thereon by attraction. The wafer stage 3 comprises an X stage which is movable along an X axis, a Y stage which is movable along a Y axis, and a Z stage which is movable along the Z axis and is rotationally movable about each of the axes parallel to the X, Y and Z axes. The X and Y axes are orthogonal to each other. Thus, driving the wafer stage 3 can serve to adjust the position of the wafer 2 surface in a direction along the optical axis AX of the reduction lens system 1 and also in a direction along a plane perpendicular to the optical axis AX. Further, it can serve to adjust any inclination of the wafer 2 surface with respect to the focal plane of the projection lens system (i.e. the formed image of the circuit pattern).

Reference numerals 4 - 11 in Figure 1 denote those elements of a detection optical system which is provided to detect the position and inclination of the wafer 2 surface. Denoted at 4 is a high-luminance light source such as a light emitting diode or a semiconductor laser, and denoted at 5 is an illumination lens. The light emanating from the light source 4 is transformed by the illumination lens into a parallel light which impinges on a mask 6 having pinholes formed therein. Plural light beams passing through the pinholes of the mask 6 then pass through an imaging lens 7 and are incident on a deflection mirror 8. The light beams deflected by the mirror 7 are incident on the wafer 2 surface. Here, the imaging lens 7 and the deflection mirror 8 serve to form images of the pinholes on the wafer 2 surface. In this particular example, the incident light beams irradiate five locations on an exposure area 100 of the wafer 2, and they are reflected at these locations, respectively. Namely, in this particular example, the mask 6 has five pinholes and, at five measuring points in each exposure area 100, the surface position is measured.

The light beams reflected at the measuring points on the wafer 2, respectively, are deflected by another deflection mirror 9 and, after passing through a detection lens 10, they are incident on a two-dimensional (area) position detecting device 11. Here, the detection lens 10 cooperates with the imaging lens 7, the deflection mirror 8, the wafer 2 and the deflection mirror 9 to form images of the pinholes of the mask 6 on the position detecting device 11. Thus, it can be stated that the mask 6, the wafer 2 and the position detecting device 11 are in an optically conjugate relationship with each other.

The position detecting device 11 may comprise a CCD array, and it serves to detect the position of incidence of each light beam upon the light receiving surface of the detecting device 11, independently of the others. Since a change in position of the wafer 2 in the direction along the optical axis AX of the projection lens system 1 can be detected as a deviation of the position of incidence of each light beam on the position detecting device 11, the position of the wafer 2 surface in the direction of the optical axis AX, at each of the five measuring points in the exposure area 100 on the wafer 2 can be detected on the basis of the output signals from the position detecting device 11. The output signals of the position detecting device are applied to a control device 13 through a signal line.

Displacement of the wafer stage 3 in each of the X axis and the Y axis can be measured in a well-known manner by using a reference mirror 15 and a laser interferometer 14, and a signal representing the displacement of the wafer stage 3 is applied to the control device 13 through a signal line. Also, the movement of the wafer stage 3 is controlled by means of a stage driving device 12. The stage driving device 12 receives an instruction signal from the control device 13 and, in response to which, it effects servo control of the wafer stage 3.

The stage driving device 12 includes first and second driving means. The first driving means serves to adjust the position (x, y) of the wafer 2 in a plane orthogonal to the optical axis AX and the rotation (θ) of the same, while the second driving means serves to adjust the position (z) of the wafer 2 in the direction of the optical axis AX and the inclination (φ_{x,y}) of the same.

The control device 13 serves to process the output signals (surface position data) from the position detecting device 11 in a manner to be described later, to determine the position of the wafer 2 surface. Also, on the basis of the result of detection, it applies a corresponding signal to the stage driving device 12. In response to the applied signal, the second driving means of the stage driving device 12 operates to adjust the position of the wafer 2 with respect to the optical axis AX direction as well as the inclination of the same.

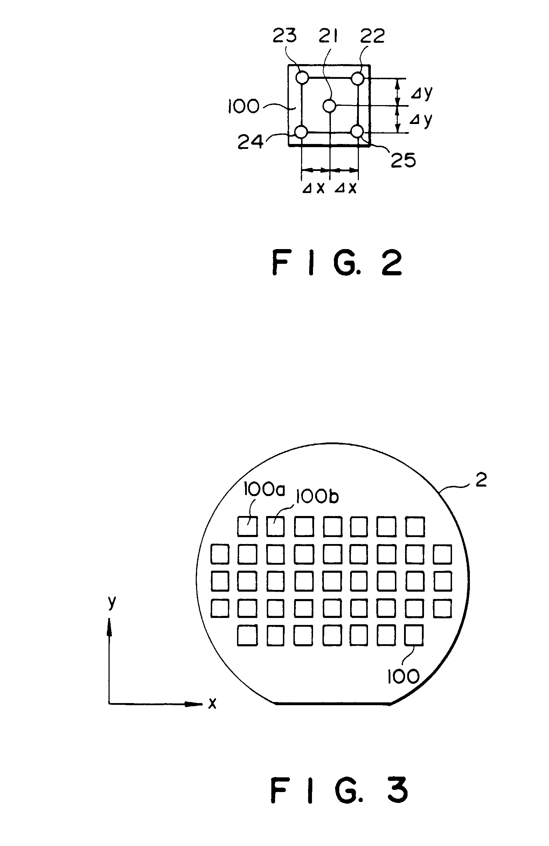

Initially, the detection optical system (4 - 11) of Figure 1 is so set to assure that, when the stage 3 is moved to a certain target position and a particular exposure area (shot area) 100 of the wafer 2 is correctly aligned with the pattern of the reticle, the images of the pinholes of the mask 6 are projected on the points 21 - 25 in that exposure area as shown in Figure 2. At this time, the particular exposure area 100 is positioned just underneath the projection lens system 1 (exposure station) and the point 21 is aligned with the optical axis AX. More specifically, as shown in Figure 2, the five points 21 - 25 are set in an exposure area 100, and the point 21 is substantially at the center of the exposure area 100. The point 21 is coincident with the optical axis AX when the exposure is done. The remaining points 22 - 25 are in a peripheral portion of the exposure area 11. If the point 21 is set at a position (x, y) in an X-Y coordinate, then the remaining points 22 - 25 are at the positions as depicted by (x+Δx, y+Δy), (x-Δx, y+Δy), (x-Δx, y- y) and (x+Δx, y-Δy), respectively. As best seen in Figure 3, all the exposure areas 11 are arrayed on the wafer 2 regularly, along the X and Y axes.

In this embodiment, the wafer stage 3 is so moved that a first exposure area 100a of the wafer 2 is moved to a position just underneath the projection lens system 1, and then the first exposure area 100 is aligned with the pattern of the reticle. Before the alignment operation is completed and when the wafer stage 3 is being moved, the detection optical system (4 - 11) is used to detect the surface positions at five points within the first exposure area 100 and, on the basis of the corresponding output signals from the position detecting device 11, the control means prepares the surface position data related to the five points. Here, each of the five points irradiated by the five light beams (pinhole images) is spaced from or in short of corresponding one of the five points 21 - 25 (Figure 2), with respect to the movement direction of the wafer stage 3, by a predetermined distance. Depending on this distance predetermined, for example, each light spot formed on the wafer may be separate from corresponding one of the points 21 - 25 or it may partially overlap that point.

Then, on the basis of the five surface position data Zi (i = 1 to 5), the control device 13 calculates a least square surface (or the position thereof) of the first exposure area 100a, and also calculates the interval between this least square surface and the image of the pattern of the reticle in the optical axis AX direction as well as the amount and direction of the inclination of the least square surface. Here, the position (z) of the least square surface is one that satisfies the following relation:

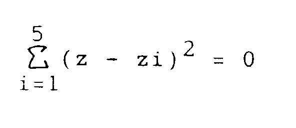

The control device 13 applies to the stage driving device 12 an instruction signal corresponding to the results of these calculations, and the stage driving device 12 operates to adjust (correct) the position in the optical axis AX direction and the inclination of the wafer 2 held on the wafer stage 3. This allows positioning of the wafer 2 surface, namely, the first exposure area 100a thereof, on the best imaging plane (focal plane) of the projection lens system 1, during movement of the wafer stage 3. After this, the movement of the wafer stage 3 to a corresponding target position (i.e. the position for placing the first exposure area 100a at the exposure station) is accomplished.

After such surface position adjustment and the wafer stage movement, the first exposure area 100a is exposed and the image of the pattern of the reticle is printed on this area.

After exposure of the first exposure area 100a, the wafer stage 3 is moved so as to move a second exposure area 100b of the wafer 2 to the position just underneath the projection lens system 1 and, in a similar manner as described above, the surface position detection and adjustment during movement of the wafer stage as well as the exposure operation after completion of the wafer stage movement are carried out. By repeating these operations, the circuit pattern of the reticle is printed on all the exposure areas, whereby one process for manufacture of semiconductor devices is completed.

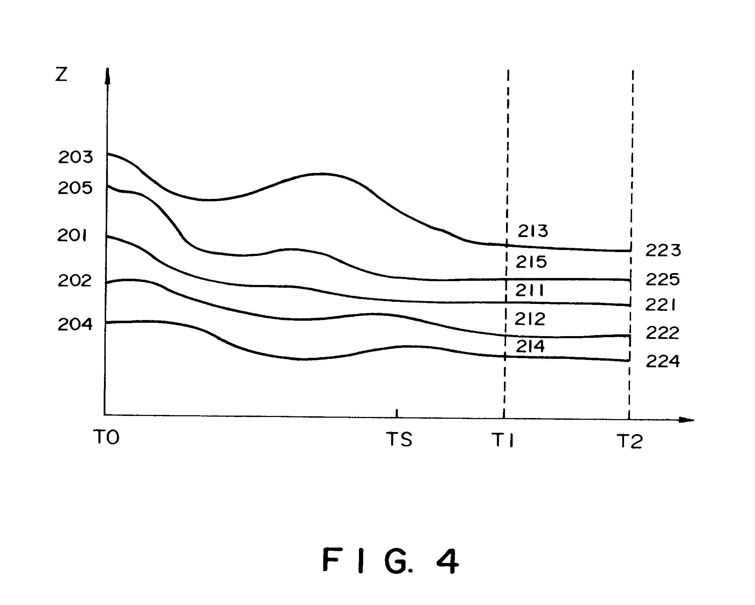

Figure 4 exemplarily shows output signals from the position detecting device 11 responsive to five light beams irradiating the wafer 2, as the wafer stage 3 is moved after the exposure of a first exposure area 100a to move a second exposure area 100b to the position just underneath the projection lens system 1.

At time T₀, the movement of the wafer stage 3 starts. The levels measured at the five points are Zᵢ₀ (i = 1 to 5). The detection optical system (4 - 11) continuously measures the surface shape of that portion of the wafer 2, from the first exposure area 100a to the second exposure area 100b, by using the five light beams. At time T₁, the center of the second exposure area 100b on the wafer 2 is positioned about 5 microns in short of or upstream of the exposure station under the projection lens system 1 (the position where the center of the exposure area 100b should be aligned with the optical axis AX). At time T₂, the second exposure area 100b is positioned just underneath the projection lens system 1, and the wafer stage 3 movement completes. At time Ts in the drawing, the center of the exposure area 100b is positioned 100 microns in short of the position aligned with the optical axis.

At time T₁, the five points irradiated by the five light beams are about 5 microns in short of the respective target positions (the points 21 - 25 on the exposure area 100b) and, as seen in the graph, from time T₁ to time T₂, the measured levels Zᵢ₁ (i = 1 to 5) related to the irradiated five points gradually converge to the levels Zᵢ₂ (i = 1 to 5) which are related to the points 21 - 25 as the wafer stage 3 movement just completes. If the position at time T₁ is set at 5 microns upstream of the exposure position, the measured levels Zᵢ₁ at that position are approximately the same as the levels Zᵢ₂, and thus they can be effectively used for the surface position adjustment to the exposure area which is just going to be exposed.

In this embodiment of the present invention, particular notice has been paid to the "continuity" of attitude in the movement as shown in Figure 4 till the completion of the wafer stage 3 movement. Just before the moving wafer stage 3 reaches its target position, the attitude thereof is approximately the same as that to be taken as the stage 3 is stopped and, by utilizing such phenomenon, the surface position measurement is executed during movement of the wafer stage 3.

In this particular example, the measurement to each exposure area 100 through the detection optical system (4 - 11) is executed while the wafer stage 3 is being moved and at time T₁ whereat the wafer stage 3 just passes a position 5 microns distant from or in short of a corresponding target position, and, on the basis of the levels Zᵢ₁ (i = 1 to 5) measured in relation to the five points at that time, the position of a least square surface of that exposure area 100 as well as the amount and direction of inclination of that exposure area, with respect to the focal plane of the projection lens system 1, are determined. Therefore, as compared with a case where the measurement starts at time T₂ as the wafer stage 3 movement just completes, reduction of time by (T₂ - T₁) is assured.

Also, in this particular example, the adjustment of the surface position and inclination of each exposure area 100 starts when the wafer stage 3 is moving, and this adjustment is accomplished before the wafer stage 3 movement finishes. With this focusing operation of this example, it is possible to increase the throughput of the apparatus largely.

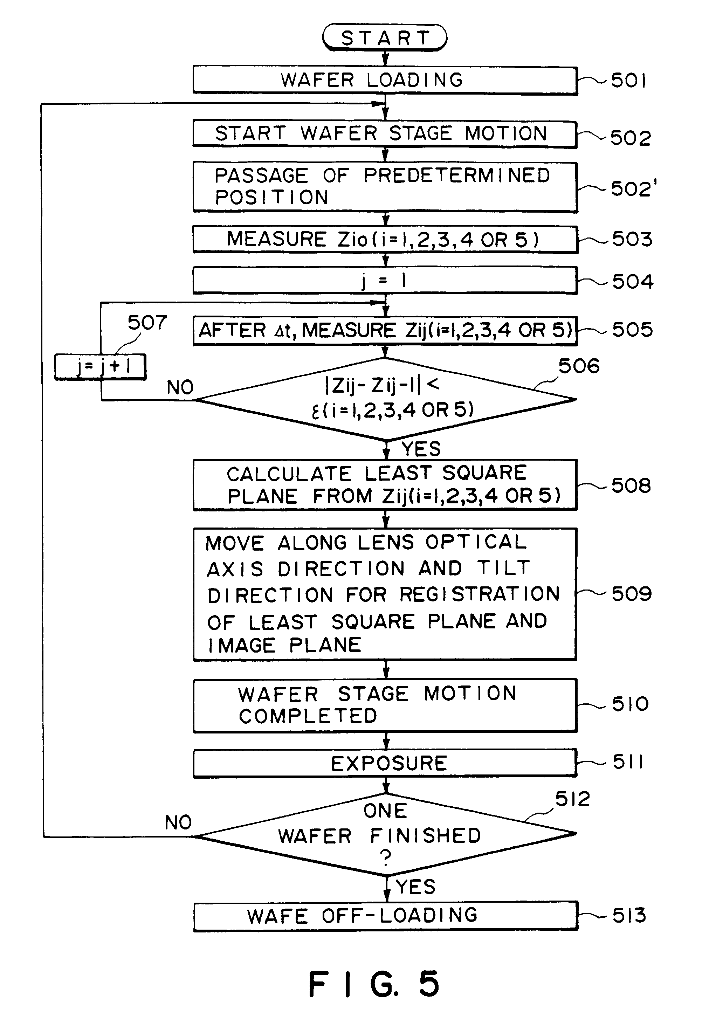

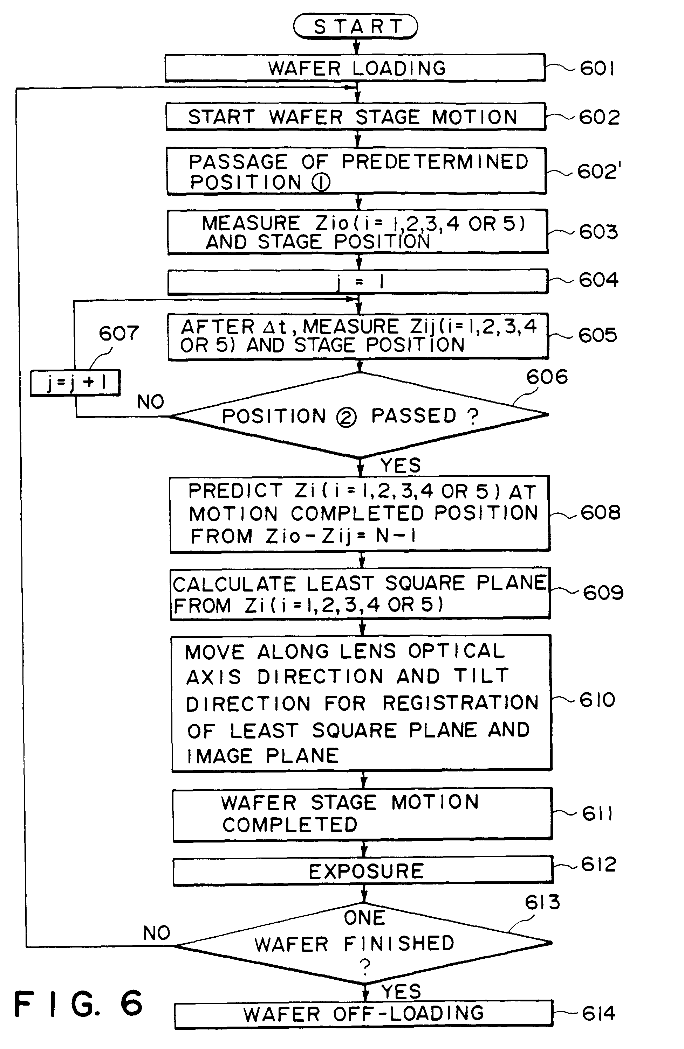

Further examples of autofocusing operation using the structure shown in Figure 1 will now be explained in conjunction with the flow charts of Figures 5 and 6. It should be noted here that the. operations according to these example can be done only with small modifications of a program to be set in the control device 14.

The sequence shown in the flow chart of Figure 5 will be first explained.

At step 501, a wafer 2 is loaded on the wafer stage 3, and the wafer 2 is held fixed on a chuck of the Z stage of the wafer stage 3. At step 502, the drive of the wafer stage 3 starts, and the wafer stage 3 starts its movement toward a target position to place a first exposure area of the wafer 2 at a position just below the projection lens system 1. At step 502', the wafer stage 3 passes a predetermined position (time Ts position in Figure 4) which is a predetermined distance (e.g. 100 microns) in short of the target position. The position of the wafer stage 3 is monitored on the basis of the output of the laser interferometer 14. At this time, as specified at step 503, surface position measurement is done to five measuring points by using the detection optical system (4 - 11), and measured levels Zᵢ₀ obtained thereby are memorized into a memory of the control device 13. Also, as specified at step 504, the control device 13 resets it counter to a value of j = 1 and, in response to this, at step 505 the detection optical system (4 - 11) measures the surface positions at five points on the moving wafer 2 at the moment of time "Ts + Δt". The levels Zᵢ₁ (i = 1 to 5) obtained by the measurement are memorized into the memory of the control device 13.

Then, at step 506, discrimination is made as to whether the difference of each level Zᵢ₁ (i = 1 to 5) measured the second time from each corresponding level Zᵢ₀ (i = 1 to 5) measured the first time (namely, Δ₁ = Z₁₁ - Z₁₀; Δ₂ = Z₂₁ - Z₂₀; Δ₃ = Z₃₁ - Z₃₀; Δ₄ = Z₄₁ - Z₄₀; and Δ₅ = Z₅₁ - Z₅₀), is greater than a predetermined amount ε or not. If all the differences Δi (i = 1 to 5) are equal to or smaller than ε, the second time measured levels Zᵢ₁ (i = 1 to 5) are taken as effective, and the sequence goes to step 508. If at least one of the differences Δi (i = 1 to 5) related to the five measuring points is larger than ε, the sequence goes to step 507 where the counter of the control device 13 is incremented to j = 2 and then the measurement at step 505 is repeated. Until all the differences i (i = 1 to 5) become equal to or smaller than ε, the operations at steps 505 - 507 are repeated.

The effective measured levels Zᵢⱼ (i = 1 to 5) are used at step 508 to calculate a least square plane. Then, the spacing of this least square plane from the focal plane of the projection lens system 1 as well as the amount and direction of inclination of the first exposure area are determined. The control device 13 applies an instruction signal, corresponding to the spacing and the amount and direction of inclination as determined, to the stage driving device 12. At step 509, the stage driving device 12 moves the Z stage to correct the position and inclination of the wafer 2 with respect to the optical axis AX direction.

After this, at step 511, the wafer stage 3 reaches it target position and thus the wafer stage 3 movement completes. At this time, through the output of the laser interferometer 14, the control device 13 detects the arrival of the wafer stage 13 at its target position and then it controls the exposure apparatus so as to start the exposure operation at step 511. At this step 511, the first exposure area of the wafer 2 is exposed to an image of a circuit pattern with radiation, and thus the circuit pattern is transferred onto a resist on this exposure area.

Then, at step 512, discrimination is made as to whether exposures of all the exposure areas on the wafer 2 have been accomplished. If accomplished, the sequence goes to step 513 and the wafer is off-loaded. If, on the other hand, all the exposures have not been accomplished (step 512) and there remains any exposure area which is unexposed, the sequence goes back to step 502 and the wafer stage 3 is driven again so as to place a second exposure area, for example, at the position just below the projection lens system 1. In this manner, the operations at steps 501 - 512 are repeated until exposures of all the exposure areas are accomplished.

Next, the sequence shown in the flow chart of Figure 6 will be explained.

In Figure 6, steps 601 and 602 are similar to steps 501 and 502 in Figure 5, and steps 610 - 614 are similar to steps 509 - 513 in Figure 5. Thus, explanation of these steps will be omitted, and only steps 602' - 609 will now be explained.

In Figure 6, a first predetermined position (1) in step 602' is set at such position that, from the surface precision of a wafer 2 or the action (such as a change in attitude) of the moving wafer stage 3, it is predicted that in the movement of the wafer stage 3 from that position to a target position a certain linear relation is substantially retained in the measured levels sequentially obtained from the detection optical system (4- 11). Also, a second predetermined position (2) is set at such position that the calculation of a least square plane at step 608 and the focusing operation at step 610 can be accomplished before the movement of the wafer stage 3 completes at step 611.

When in operation the wafer stage 3 passes the predetermined position (1) at step 602', the surface positions at five measuring points are measured (step 603) through the detection optical system (4 - 11), and the levels Zᵢ₀ (i = 1 to 5) obtained by the measurement are memorized into a memory of the control device 13. Simultaneously, the control device 13 detects the position of the wafer stage 3 on the basis of the output of the laser interferometer 14, and stores the corresponding data into the memory.

Then, at step 604, the control device 13 resets its counter to j = 1 and, in response to this and at the position corresponding to time Δt from the time as step 602 has been executed, the detection optical system (4 - 11) effects the surface position measurement to five points. The obtained levels are memorized into the memory of the control device 13. Concurrently, the position of the wafer stage at this time is detected and the corresponding data is stored into the memory.

At step 606, whether the wafer stage 3 has passed the second predetermined position (2) is discriminated on the basis of the output of the laser interferometer 14. If not yet passed, the sequence goes to step 607 whereby the measurement at step 605 is repeated. In this manner, during the movement of the wafer stage 3 from the first predetermined position (1) to the second predetermined position (2), the surface position measurement and the stage position measurement are effected by N times, using the detection optical system (4 - 11), whereby N sets of measured levels Zᵢⱼ (i = 1 - 5) are obtained. If at step 606 the passage of the wafer stage 3 through the second predetermined position (2) is discriminated, then at step 608 the N sets of measured levels Zᵢ₀ to Z_{iJ} (i = 1 to 5 and j = N - 1) and the positional data of a number N, as stored in the memory, are used to predict the levels Zᵢ (i = 1 to 5) to be measured as the wafer stage movement completes. This prediction is made on the basis of numerical calculations which are equivalent to those for obtaining, by extrapolation, the levels Zᵢ (i = 1 to 5) of the surface position at the target position, from a straight line (linear function) or a curved line (quadratic function) as can be drawn by plotting the positional data of a number N and the N sets of measured levels, while taking the positional coordinate of the stage on the axis of abscissa and taking the measured level of the surface position on the axis of ordinate. Then, at step 609, the least square surface of the exposure area of the wafer 2 is calculated on the basis of the predicted levels Zᵢ (i = 1 to 5).

In the sequences described with reference to Figures 5 and 6, whether or not an instruction signal is to be applied to the stage driving device 12 for execution of the step 509 or 610, may be discriminated on the basis of five measured levels as obtainable from the detection optical system (4 - 11) at a certain time such as time T1, namely, at the position 5 microns in short of the target position. If this is done, then it is easily possible to take appropriate measures to a large change, if any, in the surface position of the exposure area which may occur just before the wafer stage 4 completes its movement. More specifically, if the surface position as represented by the five measured levels at that position has a very small deviation from the least square surface as determined in the earlier step, an instruction signal based on the earlier step may be applied to the stage driving device 12. If the surface position as represented by the five measured levels has a non-negligible deviation from the least square surface as calculated in the earlier step, such instruction signal that corresponds to the spacing between the least square surface as calculated from these five measured levels and the focal plane of the projection lens system 1 as well as the amount and direction of inclination of the exposure area, may be applied to the stage driving device 12.

In the examples described in the foregoing, preferably the detection optical system (4 - 11) may be continuously operated until the exposure operation is executed so as to continuously monitor the surface position of the exposure area which is the subject of the exposure at that time.

While in the above-described examples the position and inclination of the surface of a wafer 2 are detected and corrected, as a matter of course, the present invention is applicable to a device by which only the position of a wafer 2 is to be detected and corrected or a device by which only the inclination of the surface of a wafer 2 is to be detected and corrected. Further, the detecting means for detecting the surface position or inclination of the wafer 2 surface is not limited to such a detection optical system (4 - 11) as shown in Figure 1. Any other type detecting means known in the art may be used. Also, the mechanism for bringing the wafer 2 surface into focus with the focal plane of the projection lens system is not limited to the one for moving the Z stage of the wafer stage 3. As an alternative to the present invention, a mechanism for changing the focal length of the projection lens system 1 or for moving the projection lens system 1 and the reticle (not shown) upwardly or downwardly along the optical axis AX, may be used.

While in the foregoing examples the invention is applied to a reduction projection exposure apparatus, the present invention is applicable also to other types of exposure apparatuses such as, for example, an apparatus for projecting an image of a pattern by using a projection mirror system or a projection optical system having lens and mirror optical systems. Additionally, the present invention is applicable also to exposure apparatuses other than optical exposure apparatuses, examples of which are an electron beam exposure apparatus wherein an electron beam is used in combination with electron lenses to project or directly draw a circuit pattern on a wafer, or an X-ray exposure apparatus using X-rays.

It is also to be noted that the present invention is not limited to such an exposure apparatus but is applicable to an optical instrument wherein high-speed and accurate autofocusing is desired.

In accordance with the above-described embodiments of the present invention, the position or inclination of a moving plate-like object such as a wafer is detected during movement of a stage which supports the object. As a result, it is possible to reduce the time for the autofocusing operation. Also, where the adjustment of the position or inclination of the surface of the object is done during the movement of the stage, further reduction in time of the focusing operation is assured.

While the invention has been described with reference to the structures disclosed herein, it is not confined to the details set forth and this application is intended to cover such modifications or changes as may come within the scope of the following claims.

## Claims

1. An autofocusing device for use in a step-and-repeat exposure apparatus having a projection optical system (1), comprising:
a holder (3) for holding a wafer (2) having a plurality of exposure areas (100; 100a; 100b);
detecting means (4-11) for detecting the position of the surface of the wafer with respect to an exposure location in the focal plane of the exposure apparatus; and
adjustment means (12, 13) adapted to move the holder both along and orthogonally with respect to the optical axis (AX) of the exposure apparatus;
characterised in that, after a first exposure area (100a) of the wafer is adjusted into alignment with the exposure location and then exposed, said detecting means operates to control said adjustment means during movement of the wafer orthogonally with respect to the optical axis on the basis of the detection of the position of the surface of the wafer during said movement so as to move a second exposure area (100b) of the wafer to the exposure location while moving the wafer along the optical axis into alignment with the focal plane of the exposure apparatus (T1) before the second exposure area (100b) is brought (T2) into alignment with the exposure location.

2. A device according to claim 1, wherein said detecting means detects inclination of the surface of the wafer with respect to the focal plane of said projection apparatus.

3. An exposure apparatus comprising an autofocus device as claimed in either of claims 1 or 2, further comprising a projection lens system (1), and being adapted to sequentially expose a plurality of different exposure areas of a wafer to a beam from said projection lens system.

4. A method of exposing a wafer (2) using a step-and-repeat exposure apparatus having a projection lens optical system (1), comprising:
holding in a holder (3) a wafer (2) having a plurality of exposure areas (100; 100a; 100b);
detecting using detecting means (4-11) the position of the surface of the wafer with respect to an exposure location in the focal plane of the exposure apparatus; and
utilizing adjusting means (12, 13) to move the holder both along and orthogonally with respect to the optical axis (AX) of the exposure apparatus, the method being
characterised by, after a first exposure area (100a) of the wafer is adjusted into alignment with the exposure location and then exposed, controlling said adjustment means by means of said detecting means during movement of the wafer orthogonally with respect to the optical axis on the basis of the detection of the position of the surface of the wafer during said movement so as to move a second exposure area (100b) of the wafer to the exposure location while moving the wafer along the optical axis into alignment with the focal plane of the exposure apparatus (T1) before the second exposure area (100b) is brought (T2) into alignment with the exposure location.

5. A method according to claim 4, wherein inclination of the surface of the wafer is also detected.

6. A method according to claim 4 or claim 5, including repeatedly moving a plurality of exposure areas of the wafer into said exposure station and exposing said areas to the projection lens system.

## Patentansprüche

1. Automatische Fokussierungsvorrichtung zur Verwendung in einem Step-und-Repeat-Belichtungsgerät mit einem optischen Projektionssystem **(1)**, welche aufweist:
- eine Halteeinrichtung **(3)** zum Halten eines Wafers **(2)** mit einer Vielzahl von Belichtungsflächen **(100, 100a, 100b),**
- eine Erfassungseinrichtung **(4 - 11)** zum Erfassen der Position der Oberfläche auf dem Wafer mit Bezug auf einen Belichtungsort in der Bildebene des Belichtungsgeräts und
- eine Justiereinrichtung **(12, 13),** die angepaßt ist, die Halteeinrichtung sowohl entlang der optischen Achse **(AX)** als auch rechtwinklig mit Bezug auf die optische Achse **(AX)** des Belichtungsgeräts zu bewegen,
**dadurch gekennzeichnet, daß** nachdem eine erste Belichtungsfläche **(100a)** auf dem Wafer in Justierung mit dem Belichtungsort eingestellt und dann belichtet ist, die Erfassungseinrichtung betriebswirksam wird, um die Justiereinrichtung während der Bewegung des Wafers rechtwinklig mit Bezug auf die optische Achse auf der Grundlage der Erfassung der Position auf der Oberfläche auf dem Wafer während der Bewegung zu steuern, um eine zweite Belichtungsfläche **(100b)** auf dem Wafer zum Belichtungsort zu bewegen, während der Wafer entlang der optischen Achse in die Justierung mit der Bildebene des Belichtungsgeräts bewegt wird **(T1)**, bevor die zweite Belichtungsfläche **(100b)** in die Justierung mit dem Belichtungsort versetzt wird.

2. Automatische Fokussierungsvorrichtung gemäß Anspruch 1, wobei die Erfassungseinrichtung die Neigung der Oberfläche auf dem Wafer mit Bezug auf die Bildebene des Projektionsgeräts erfaßt.

3. Belichtungsgerät, welches eine automatische Fokussierungsvorrichtung gemäß einem der Ansprüche 1 oder 2 aufweist und ferner ein Projektionslinsensystem **(1)** aufweist und angepaßt ist, um aufeinanderfolgend eine Vielzahl von unterschiedlichen Belichtungsflächen eines Wafers mit einem Strahl vom Projektionslinsensystem zu belichten.

4. Verfahren zur Belichtung eines Wafers **(2)** unter Verwendung eines Step-und-Repeat-Belichtungsgeräts mit einem optischen Projektionslinsensystem **(1)**, welches aufweist:
- Halten eines Wafers **(2)** mit einer Vielzahl von Belichtungsflächen **(100, 100a, 100b)** in einer Halteeinrichtung **(3)**,
- Erfassen der Position der Oberfläche auf dem Wafer mit Bezug auf einen Belichtungsort in der Bildebene des Belichtungsgeräts unter Verwendung der Erfassungseinrichtung **(4 - 11)**, und
- Verwenden der Justiereinrichtung **(12, 13)**, um die Halteeinrichtung sowohl entlang der optischen Achse **(AX)** als auch rechtwinklig mit Bezug auf die optische Achse **(AX)** des Belichtungsgeräts zu bewegen, wobei das Verfahren
**dadurch gekennzeichnet** ist, daß nach dem Justieren einer ersten Belichtungsfläche **(100a)** auf dem Wafer in Justierung mit dem Belichtungsort und dann dem Belichten die Erfassungseinrichtung die Justiereinrichtung mittels der Erfassungseinrichtung während der Bewegung des Wafers rechtwinklig mit Bezug auf die optische Achse auf der Grundlage der Erfassung der Position der Oberfläche des Wafers während der Bewegung steuert, um eine zweite Belichtungsfläche **(100b)** auf dem Wafer zum Belichtungsort zu bewegen, während der Wafer entlang der optischen Achse in die Justierung mit der Bildebene des Belichtungsgeräts bewegt wird **(T1)**, bevor die zweite Belichtungsfläche **(100b)** in die Justierung mit dem Belichtungsort versetzt wird **(T2)**.

5. Verfahren gemäß Anspruch 4, wobei die Neigung der Oberfläche des Wafers ebenfalls erfaßt wird.

6. Verfahren gemäß Anspruch 4 oder Anspruch 5, welches das wiederholte Bewegen einer Vielzahl von Belichtungsflächen des Wafers in die Belichtungsstation und das Belichten der Flächen in dem Projektionslinsensystem aufweist.

## Revendications

1. Dispositif de mise au point automatique destiné à être utilisé dans un appareil d'exposition pour gravure par projection répétitive ayant un système optique (1) de projection, comportant :
un support (3) destiné à porter une tranche (2) ayant une pluralité de zones d'exposition (100, 100a, 100b) ;
des moyens de détection (4-11) destinés à détecter la positoin de la surface de la tranche par rapport à un emplacement d'exposition dans le plan focal de l'appareil d'exposition ; et
des moyens de réglage (12, 13) conçus pour déplacer le support à la fois le long de l'axe optique (AX) de l'appareil d'exposition et orthogonalement à cet axe optique (AX) ;
caractérisé en ce que, après qu'une première zone d'exposition (100a) de la tranche a été amenée par réglage en alignement avec l'emplacement d'exposition et ensuite exposée, lesdits moyens de détection agissent de façon à commander lesdits moyens de réglage pendant un mouvement de la tranche orthogonalement par rapport à l'axe optique sur la base de la détection de la position de la surface de la tranche pendant ledit mouvement afin d'amener une deuxième zone d'exposition (100b) de la tranche à -l'emplacement d'exposition tout en déplaçant la tranche le long de l'axe optique jusqu'à l'alignement avec le plan focal de l'appareil d'exposition (T1) avant que la deuxième zone d'exposition (100b) soit amenée (T2) en alignement avec l'emplacement d'exposition.

2. Dispositif selon la revendication 1, dans lequel lesdits moyens de détection détectent une inclinaison de la surface de la tranche par rapport au plan focal dudit appareil de projection.

3. Appareil d'exposition comportant un dispositif de mise au point automatique selon l'une des revendications 1 ou 2, et comportant en outre un système (1) de lentilles de projection, et étant conçu pour exposer séquentiellement plusieurs zones d'exposition différentes d'une tranche à un faisceau dudit système de lentilles de projection.

4. Procédé d'exposition d'une tranche (2) en utilisant un appareil d'exposition pour gravure par projection répétitive ayant un système optique (1) de lentilles de projection, comprenant :
le maintien dans un support (3) d'une tranche (2) ayant plusieurs zones d'exposition (100, 100a, 100b) ;
la détection, en utilisant des moyens de détection (4-11), de la position de la surface de la tranche par rapport à un emplacement d'exposition dans le plan focal de l'appareil d'exposition ; et
l'utilisation de moyens de réglage (12, 13) pour déplacer le support à la fois le long de l'axe optique (AX) de l'appareil d'exposition et orthogonalement par rapport à cet axe optique (AX), le procédé étant
caractérisé par, après le réglage d'une première zone d'exposition (100a) de la tranche jusqu'en alignement avec l'emplacement d'exposition puis son exposition, la commande desdits moyens de réglage au moyen desdits moyens de détection pendant un mouvement de la tranche orthogonalement par rapport à l'axe optique sur la base de la détection de la partie de la surface de la tranche pendant ledit mouvement afin d'amener une deuxième zone d'exposition (100b) de la tranche à l'emplacement d'exposition tout en déplaçant la tranche le long de l'axe optique jusqu'en alignement avec le plan focal de l'appareil d'exposition (T1) avant que la deuxième zone d'exposition (100b) soit amenée (T2) en alignement avec l'emplacement d'exposition.

5. Procédé selon la revendication 4, dans lequel une inclinaison de la surface de la tranche est également détectée.

6. Procédé selon la revendication 4 ou 5, comprenant le déplacement répété de plusieurs zones d'exposition de la tranche jusque dans ledit poste d'exposition et l'exposition desdites zones au système de lentilles de projection.
